# EUROPÄISCHE PATENTSCHRIFT

(11) **EP 0 847 545 B1**
(45) Veröffentlichungstag und Bekanntmachung des Hinweises auf die Patenterteilung: **16.02.2000**
(21) Anmeldenummer: 96944547.7
(22) Anmeldetag: 24.08.1996
(51) Int. Cl.: G03F 7/36, G03F 7/40

(54) **VERFAHREN ZUR VERBESSERUNG DES KONTRASTES BEI DER STRUKTURIERUNG VON 3-DIMENSIONALEN OBERFLÄCHEN**
PROCESS FOR IMPROVING THE CONTRAST IN THE STRUCTURING OF 3-DIMENSIONAL SURFACES
PROCEDE POUR AMELIORER LE CONTRASTE LORS DE LA STRUCTURATION DE SURFACES TRIDIMENSIONNELLES

(30) Priorität: 30.08.1995 DE 19531859; 13.07.1996 DE 19628353
(43) Veröffentlichungstag der Anmeldung: 17.06.1998
(73) Patentinhaber: Deutsche Telekom AG, 53113 Bonn (DE)
(72) Erfinder: KOOPS, Hans, Wilfried, Peter, D-64372 Ober-Ramstadt (DE); BABINE, Sergey, D-64347 Griesheim (DE); DAHM, Gerold, D-63906 Erlenbach (DE); HOLOPKIN, Alexey, Moskau (RU)
(74) Vertreter: Kampfenkel, Klaus, Dipl.-Ing.
(86) Internationale Anmeldenummer: DE9601580
(87) Internationale Veröffentlichungsnummer: WO9710088

(56) Entgegenhaltungen:
- WO-A-95/02472
- US-A- 4 430 153
- MICROELECTRONIC ENGINEERING, Bd. 23, Nr. 1/04, 1.Januar 1994, Seiten 303-305, XP000418646 BABIN S V ET AL: "INVESTIGATION OF NEW DRY HIGH SENSITIVE RESIST USING 100 KV ELECTRON LITHOGRAPHY"
- THIN SOLID FILMS, Bd. 101, 1983, Seiten 369-372, XP000647428 V.P. KORCHKOV ET AL.: "All-Dry Vacuum Submicron Lithography" in der Anmeldung erwähnt

## Beschreibung

Die erfindungsgemäße Lösung bezieht sich auf die Verbesserung des Kontrastes von in Trockentechnologie erzeugten 3-dimensionalen Strukturen. Da seit langem Bestrebungen dahin gehen, trocken aufzubringende strahlungsempfindliche Schichten zu erzeugen und einzusetzen, wird auch mittels des erfindungsgemäßen Verfahrens ein durchgängig auf trockenen Prozeßschritten basierender Lithographieprozeß angestrebt. Damit wäre nicht nur eine saubere Prozeßführung gewährleistet, sondern es würden auch keine umwelt- und gesundheitsschädlichen Substanzen im Verfahrensprozeß frei.

Bekannt sind Bestrebungen, elektronenempfindliche Polymerisate in der Gasentladung zu erzeugen, deren Anwendungen noch offen stehen. Siehe
1. O. Joubert, T. Weidmann, A. Joshi, R. Cirelli, S. Stein, J. T. C. Lee, S. Vaidya: "Plasma polymerized all-dry resist process for 0.25 um photolithography", J. Vac. Technol. B 12(6) (1995), 3909.
   Am Techno-Centre in Moskau wurde für die Korpuskularstrahlund optische Lithographie eine Substanz als Trockenlack synthetisiert, der mit einer Empfindlichkeit ähnlich der des bekannten Elektronenlacks PMMA (Polymethylmetacrylat), aber als Negativlack, arbeitet. Dieser Lack besitzt einen schlechten Kontrast und auf Festkörpern für Lithographie nur ein bedingt geeignetes Auflösungsvermögen. Er wird im Vakuum aufgedampft und auch im Vakuum trocken entwickelt. Siehe
2. P. Guttmann, G. Daney, I. Spassova, S. Babin: "Behaviour of amorphous As₂S₃-Layers after photon, electron. and X-ray exposures", SPIE 1361 (1990) 999.
   Nasse Prozeßschritte werden überflüssig. Dadurch ist der Lack sehr umweltfreundlich. Siehe
3. V. P. Korchcov, T. N. Martynova, V. S. Danilovich: "Thin Solid Films", Band 101, 1983, Seiten 369-372.

Der Lack besitzt eine hohe Ätzresistenz gegen Metalle ätzende Plasmaprozesse und findet daher bevorzugt als gute Ätzmaske Verwendung.

Mittels des erfindungsgemäßen Verfahrens soll insgesamt ein besserer Kontrast des Trockenlackes und auf Festkörpern ein besseres Auflösungsvermögen bewirkt werden, so daß der Trockenlack auch für die optische Lithographie eingesetzt werden kann.

Die erfindungsgemäße Lösung, wie in Anspruch 1 beschrieben, basiert auf einem der thermischen Entwicklung des Trockenlackes nachgeordneten Trockenätz-Schritt, durch den insbesondere der Kontrast des Trockenlackes wesentlich verbessert wird. Bei der Belichtung polymerisiert das stark siliziumdioxidhaltige Grundmaterial durch den Strahlenbeschuß. Da ein großer Teil der Strahlung bei Elektronenbelichtung durch den Proximity-Effekt in die Umgebung der belichteten Stellen gestreut wird, ist in nicht direkt belichteten Bereichen bereits ein schwach polymerisiertes Material vorzufinden, das durch die thermische Entwicklung nicht mehr zu entfernen ist. Das erfindungsgemäße Verfahren ist vorzugsweise auf die Beseitigung dieses schwach polymerisierten Materials, durch das der schlechte Kontrast bewirkt wird, ausgerichtet. Dieses beruht auf einem

Ätzangriff von reaktiven Fluor-Ionen , die in der Gasentladung im Parallelplattenreaktor aus CF₄ entstehen. Die Entfernung des schwach polymerisierten Materials erfolgt dadurch ebenfalls in einem Trocken-Prozeß. Eine weitere Nachbehandlung ist nicht notwendig. Mittels des erfindungsgemäßen Verfahrens wird ein verbesserter Kontrast erreicht und ein erhöhtes Auflösungsvermögen des Lackes erzielt.

Die erfindungsgemäße Lösung soll anhand eines Ausführungsbeispiels näher erläutert werden.

Im Ausführungsbeispiel wird als Trockenlack Octavinylsilsesquioxan eingesetzt. Dieser Trockenlack, der als Negativlack wirkt, besitzt eine Empfindlichkeit, die ähnlich der Empfindlichkeit des bekannten Elektronenlackes PMMA (Polymethylmetacrylat) ist.

Octavinylsesquisiloxan besitzt einen schlechten Kontrast, sowie auf Festkörpern für Lithographie nur ein bedingt geeignetes Auflösungsvermögen.
Der Lack wird im Hochvakuum bei niedrigen Temperaturen auf die 3-dimensionale Oberfläche aufgedampft. Die Belichtung des Lackes erfolgt über Elektronen-Strahlung oder aber auch durch ultraviolettes Licht bzw. Ionenstrahlen. Der Lack polymerisiert durch die Einwirkung der Strahlung. Dadurch wirkt er als Negativlack. Für verschieden dosierte Elektronenenergien besitzt der Lack unterschiedliche Empfindlichkeiten, die im Zusammenhang mit den verschieden dosierten Elektronenenergien auch einen unterschiedlichen Polymerisationsgrad des Lackes bewirken. Die Entwicklung des belichteten Lackes erfolgt ebenfalls im Hochvakuum durch Erwärmen auf Temperaturen bis 200° C. Das nicht polymerisierte Material wird bei diesem Prozeß sublimiert. Es entsteht eine 3-dimensionale optische Oberfläche mit Zonen, die einen unterschiedlichen Polymerisationsgrad aufweisen.

Da ein großer Teil der Strahlung bei Elektronenbelichtung durch den Proximity-Effekt in die Umgebung der belichteten Bereiche gestreut wird, tritt auch in nicht direkt beleuchteten Bereichen ein schwacher Polymerisationseffekt auf, so daß dort in geringem Maße polymerisiertes Material vorhanden ist, welches sich bei der thermischen Entwicklung nicht entfernen läßt. Daher ist der durch diesen Prozeß erzielbare Kontrast sehr gering. Bis zu diesem Schritt ist das Verfahren daher für hochauflösende Lithographie kaum einsetzbar.

Erfindungsgemäß wird insbesondere zur Erhöhung des Kontrastes nach der thermischen Entwicklung ein weiterer zusätzlicher Verfahrensschritt angeschlossen, der einen Trockenätz-Prozeß beinhaltet. Dabei wird das polymerisierte Material in einem Parallelplattenreaktor einem reaktiven Plasma aus Tetrafluor-Kohlenstoff ausgesetzt. Da das Polymerisat einen unterschiedlichen Polymerisationsgrad und damit eine unterschiedliche Härte besitzt, wird das weichere, nicht vollständig polymerisierte Material zuerst abgetragen. Dadurch erhöht sich der Kontrast der charakteristischen Kurve des Lackes beträchtlich, so daß ein sehr guter Kontrast von > 2,9 erreichbar ist. Damit ist der Lack als Negativlack in lithographischen Aufgaben einsetzbar. Ein weiterer Entwicklungsprozeß oder Reinigungsprozeß ist anschließend nicht erforderlich. Bei diesem Verfahren kommt man bei strukturerzeugenden Prozessen ohne im "Nassen" verlaufende Verfahrenschritte aus, so daß keine schädlichen Lösungsmittel mehr erforderlich sind. Da auch der Lackauftrag und die thermische Entwicklung des Lackes im Hochvakuum verlaufen, ist eine Gesundheitsgefährdung faktisch ausgeschlossen.

Der erzielte Kontrast γ=[log(*D*/*D*_{*o*})]⁻¹ steigt durch den erfindungsgemäßen Verfahrensschritt von 0,71 nach der thermischen Entwicklung auf 2,9. In einigen eingeschränkten Bereichen steigt der Kontrast bis zu 4,6. Dies stellt eine wesentliche Verbesserung dar und ermöglicht es, diesen Lack nun auch lithographisch zu nutzen. Nach dem erfindungsgemäßen Verfahrensschritt, d. h. nach dem trockenen Ätzentwicklungsschritt, sind keine weiteren Schritte zur Fertigstellung mehr erforderlich.
Durch den trockenen Ätzentwicklungsschritt wird auch auf dicken Unterlagen, bei denen die Elektronen-Rückstreuung die Auflösung verschlechtert, eine verbesserte Auflösung erzielt.

Das erfindungsgemäße Verfahren zeichnet sich insbesondere auch dadurch aus, daß keine umwelt- oder gesundheitsschädlichen Substanzen im Prozeß freigesetzt werden. Alle Prozesse finden im Hochvakuum statt.

## Patentansprüche

1. Verfahren zur Verbesserung des Kontrastes bei der Strukturierung von 3-dimensionalen Oberflächen, die durch Trockenlacktechnik mit stark siliziomoxidhaltigen, als Negativlack wirkenden, polymerisierbareren Trockenlacken erzeugt, mit unterschiedlicher Intensität belichtet und thermisch entwickelt wurden,
**dadurch gekennzeichnet,**
daß die mit unterschiedlichem Polymerisationsgrad polymerisierten Lack-Zonen einem zeitlich begrenzten Trockenätzprozeß in fluorhaltigem Plasma ausgesetzt werden, bei welchem ein Abtragvorgang einsetzt, der in Abhängigkeit von einer zeitlich definierbaren Funktion vom nicht vollständig polymerisierten Material zum vollständig polymerisierten Material abläuft.

2. Verfahren nach Anspruch 1, dadurch gekennzeichnet, daß der Trockenätzprozeß zeitlich so bemessen wird, daß er auf die Zonen des polymerisierten Materials beschränkt bleibt, welche durch den Proximity-Effekt belichtet und dadurch nur in geringem Maße polymerisiert wurden.

3. Verfahren nach Anspruch 1, dadurch gekennzeichnet, daß als Trockenlack Octavinylsilsesquioxan eingesetzt wird.

4. Verfahren nach Anspruch 1, dadurch gekennzeichnet, daß der Trockenätzprozeß in einem Parallelplattenreaktor mit einer Prozeßkammer aus Aluminium erfolgt, bei dem die unterschiedlich polymerisierten Lack-Zonen der 3-dimensionalen Oberfläche zeitlich begrenzt einem reaktiven Plasma aus Tetrafluor-Kohlenstoff ausgesetzt werden.

## Claims

1. A process for improving the contrast in the structuring of 3-dimensional surfaces which are produced by dry resist technique with dry resists which have a high silicon dioxide content, act as a negative resist and are more polymerisable, are exposed with different intensities and thermally developed,
characterised in that the resist zones polymerised with different degrees of polymerisation are exposed to a time-limited dry etching process in fluorine-containing plasma, in which process an abrasion process starts which progresses from incompletely polymerised material to completely polymerised material in dependence on a time-definable function.

2. A process according to Claim 1, characterised in the dry etching process is so timed as to remain restricted to those zones of the polymerised material which were exposed by the proximity effect and hence were polymerised only to a minor degree.

3. A process according to Claim 1, characterised in that the dry resist used is octavinylsilsesquioxan.

4. A process according to Claim 1, characterised in that the dry etching process is carried out in a parallel plate reactor with a process chamber'of aluminium, in which process the differently polymerised resist zones of the 3-dimensional surface are exposed in time-limited relationship to a reactive plasma of tetrafluorocarbon.

## Revendications

1. Procédé pour améliorer le contraste dans la structuration de surfaces tridimensionnelles qui ont été produites par la technique d'application de laques par voie sèche avec des laques à sec polymérisables, à forte teneur en oxyde de silicium, agissant comme laque négative, exposées à différentes intensités de rayonnement et développées thermiquement, caractérisé en ce que les zones de laque polymérisées à un degré de polymérisation différent sont exposées à un processus d'attaque corrosive à sec limité dans le temps dans un plasma contenant du fluor, dans lequel s'amorce un processus d'érosion qui s'accomplit, selon une fonction définissable dans le temps, de la matière incomplètement polymérisée à la matière totalement polymérisée.

2. Procédé suivant la revendication 1, caractérisé en ce que le processus d'attaque corrosive à sec est calculé dans le temps de manière qu'il reste limité aux zones de la matière polymérisée qui ont été exposées par l'effet de proximité et qui n'ont ainsi état polymérisées que dans une faible mesure.

3. Procédé suivant la revendication 1, caractérisé en ce qu'on utilise comme laque à sec l'octavinylsilsesquioxane.

4. Procédé suivant la revendication 1, caractérisé en ce que le processus d'attaque corrosive à sec s'effectue dans un réacteur à plaques parallèles comprenant une chambre de traitement en aluminium dans laquelle les zones de laque différemment polymérisées de la surface tridimensionnelle sont exposées de façon limitée dans le temps à un plasma réactif de tétrafluorure de carbone.
